Europäisches Patentamt

European Patent Office

Office européen des brevets

(11) Numéro de publication: **0 401 135**
**A1**

## (12) DEMANDE DE BREVET EUROPEEN

(21) Numéro de dépôt: **90420258.7**

(22) Date de dépôt: **30.05.90**

(51) Int. Cl.5: **H01L 21/82, H01L 27/06**

(30) Priorité: **02.06.89 FR 8907819** .

(43) Date de publication de la demande:
**05.12.90 Bulletin 90/49**

(84) Etats contractants désignés:
**DE ES FR GB IT NL SE**

(71) Demandeur: **SGS THOMSON MICROELECTRONICS SA**
**7, Avenue Galliéni**
**F-94250 Gentilly(FR)**

(72) Inventeur:. **Jimenez, Jean**
**4, Rue Victor Hugo**
**F-38500 Voiron(FR)**

(74) Mandataire: **de Beaumont, Michel**
**1bis, rue Champollion**
**F-38000 Grenoble(FR)**

(54) **Procédé de fabrication simultanée de transistors MOS à canal N et de transistors bipolaires verticaux PNP.**

(57) La présente invention concerne un procédé de fabrication d'un circuit intégré comprenant notamment des transistors MOS à canal et des transistors bipolaires verticaux PNP. Ce procédé comprend les étapes successives suivantes, réalisées après formation des grilles des transistors MOS :
- implanter une région N- (44 ; 45, 46) et recuire, ·
- implanter une région N+ (55 ; 53, 54) sauf dans un emplacement où sera formé l'émetteur du transistor bipolaire et recuire,
- implanter une région P + (61) là où on veut former l'émetteur du transistor bipolaire et recuire,
- les implantations et recuits des régions à haut niveau de dopage du premier et du deuxième type de conductivité étant réalisés de sorte qu'il demeure une partie de la couche résultant de l'implantation du premier type de conductivité à faible niveau de dopage sous chacune de ces régions.

Figure 12

EP 0 401 135 A1

La présente invention concerne le domaine de la fabrication des circuits intégrés.

Avec les progrès de la technologie, on voit actuellement se développer des circuits intégrés de plus en plus complexes intégrant un grand nombre de composants de types différents : des transistors MOS et des transistors bipolaires, ces transistors bipolaires comprenant des transistors logiques et des transistors de puissance, c'est-à-dire des transistors pouvant supporter des tensions et laisser passer des courants importants par rapport aux transistors logiques. La réalisation de telles structures entraîne la prévision d'un grand nombre d'étapes de fabrication, et notamment d'un grand nombre d'étapes de masquage (niveaux de masque) et d'étapes d'implantation, d'isolement et de recuit. Pour arriver à des coûts et à des rendements de fabrication raisonnables, il convient inévitablement de réaliser des compromis. Alors que l'on sait, quand il s'agit de réaliser des composants individuels, quelle structure et quels niveaux de dopage il convient de leur donner pour atteindre des performances optimales, dans le cadre de la réalisation d'un circuit intégré complexe, on est amené à sacrifier des performances d'un certain nombre de ces composants pour arriver à les intégrer sur une même puce.

C'est donc un objet constant de la recherche dans le domaine de la fabrication des circuits intégrés que de rechercher des procédés de fabrication permettant d'optimiser simultanément des composants de types différents tout en minimisant le nombre d'étapes de fabrication.

La présente invention vise une technologie de circuits intégrés du type de celle mise en oeuvre par la demanderesse et décrite dans le brevet des Etats-Unis d'Amérique N° 4 628 341.

La présente invention vise plus particulièrement un procédé de fabrication dans lequel on optimise simultanément des transistors MOS à canal d'un premier type de conductivité et des transistors bipolaires verticaux à émetteur et collecteur du type de conductivité opposé, c'est-à-dire par exemple des transistors MOS à canal N et des transistors bipolaires de type PNP vertical.

Pour atteindre ces objets, la présente invention prévoit un procédé dans lequel les transistors MOS sont du type DDD, c'est-à-dire que les régions de source et de drain à haut niveau de dopage sont insérées dans des cuvettes du même type de conductivité pénétrant un peu plus latéralement sous la grille. (La structure DDD (drain double diffusé) permet notamment de réduire la dérive dans le temps des caractéristiques des transistors MOS).

Selon l'invention, les cuvettes de plus faible niveau de dopage dans lesquelles sont implantées les régions de contact de source et de drain du transistor MOS à canal N sont réalisées en même temps que les bases des transistors PNP, tandis que les régions de contact de source et de drain du transistor MOS à canal N sont réalisées en même temps que la région de contact de base du transistor PNP.

En d'autres termes, la présente invention réside dans un procédé de fabrication d'un circuit intégré comprenant notamment des transistors MOS à canal d'un premier type de conductivité et des transistors bipolaires verticaux du type à émetteur-collecteur du deuxième type de conductivité ; ces transistors étant formés dans des caissons du deuxième type de conductivité à faible niveau de dopage sur des couches enterrées du deuxième type de conductivité à fort niveau de dopage, chacun de ces caissons étant délimité latéralement par une enceinte d'isolement et étant partagé par une bande d'isolement en une région principale et une région auxiliaire, la partie superficielle des régions auxiliaires étant dopée selon le second type de conductivité et à haut niveau de dopage ; ces régions auxiliaires correspondant au collecteur du transistor bipolaire et à la zone de contact de caisson du transistor MOS ; une grille séparant en deux parties la région principale du transistor MOS.

Ce procédé comprend les étapes successives suivantes, réalisées dans lesdites régions principales après formation des grilles des transistors MOS :

- implanter une région du premier type de conductivité à faible niveau de dopage et recuire,

- implanter une région du premier type de conductivité à haut niveau de dopage sauf dans un emplacement où sera formé l'émetteur du transistor bipolaire et recuire,

- implanter une région du deuxième type de conductivité et à haut niveau de dopage là où on veut former l'émetteur du transistor bipolaire et recuire,

- les implantations et recuits des régions à haut niveau de dopage du premier et du deuxième type de conductivité étant réalisés de sorte qu'il demeure une partie de la couche résultant de l'implantation du premier type de conductivité à faible niveau de dopage sous chacune de ces régions.

Ces objets, caractéristiques et avantages ainsi que d'autres de la présente invention seront exposés plus en détail dans la description suivante d'un mode de réalisation particulier faite en relation avec les figures jointes, parmi lesquelles :

les figures 1 à 13 illustrent des étapes de fabrication simultanée d'un transistor MOS à canal N et d'un transistor PNP vertical selon la présente invention ; et

la figure 14 représente un exemple de divers composants fabriqués en même temps que les composants plus particulièrement décrits précédemment sur une même plaquette de circuits intégrés.

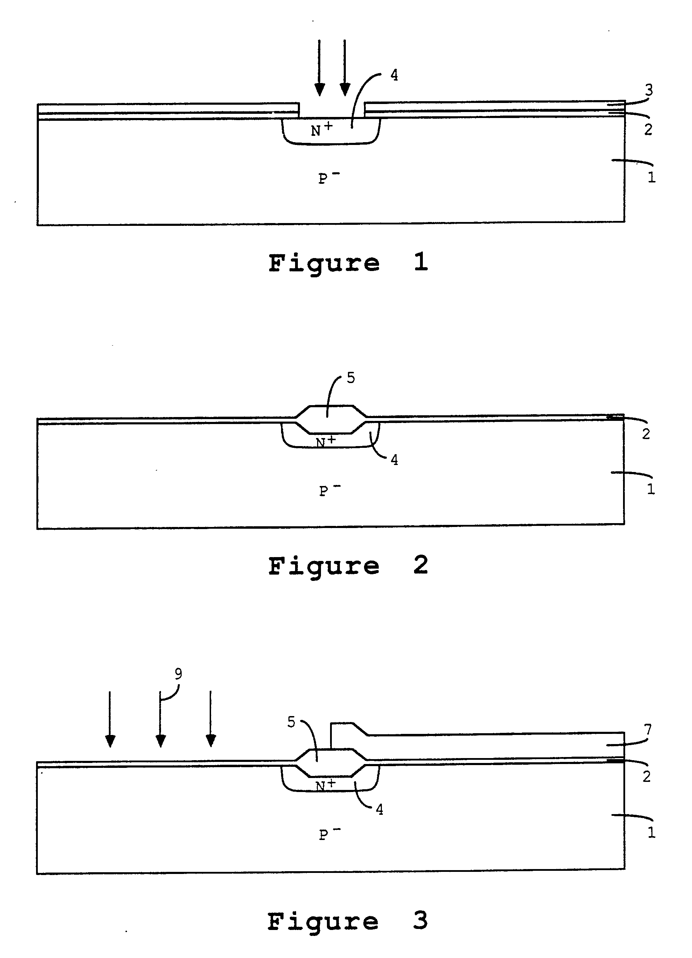

On va décrire de façon détaillée un mode de réalisation de la présente invention en relation avec les étapes successives des figures 1 à 13. On notera que dans ces diverses figures, comme cela est usuel dans le domaine de la représentation des circuits intégrés, les épaisseurs et dimensions latérales des diverses couches ne sont pas tracées à l'échelle ni à l'intérieur d'une même figure ni d'une figure à l'autre pour améliorer la lisibilité de ces figures. Par ailleurs, de mêmes références désigneront de mêmes éléments ou couches, éventuellement à des stades successifs de fabrication.

La figure 1 représente un substrat 1 de type P- sur lequel on a formé des couches successives de $SiO_2$ et de nitrure 2 et 3, la couche de $SiO_2$ ayant par exemple une épaisseur de 50 à 100 nm et la couche de nitrure une épaisseur de 100 à 150 nm. Une ouverture est formée dans les couches d'oxyde et de nitrure pour permettre l'implantation d'une région 4 de type N+. Cette région de type N+ peut par exemple résulter d'une implantation d'arsenic (As) ou d'antimoine (Sb) sous une énergie de 80 keV et une dose de 4 à 5 $10^{15}$ atomes par $cm^2$.

On va décrire ci-après la formation d'un transistor MOS à canal N dans la partie droite et la fabrication d'un transistor bipolaire vertical de type PNP dans la partie gauche des figures 1 à 13.

A l'étape suivante, on fait une croître une couche d'oxyde épais 5 dans les régions non protégées par la couche de nitrure 3. Cet oxyde épais aura par exemple une épaisseur de 200 à 300 nm résultant d'un recuit à 1160°C en présence d'oxygène. Ensuite, la couche de nitrure 3 est enlevée et l'on arrive à la structure de la figure 2.

Dans la figure 3, une couche de résine 7 masque la partie droite de la figure (celle où doit être formé un transistor MOS à canal N) et la partie gauche de la figure (celle où doit être formé un transistor PNP) subit une implantation 9 de dopant de type N, par exemple des ions de phosphore, sous une énergie de 100 keV avec une dose de $10^{13}$ atomes par $cm^2$, c'est-à-dire une implantation devant conduire à une couche relativement peu dopée.

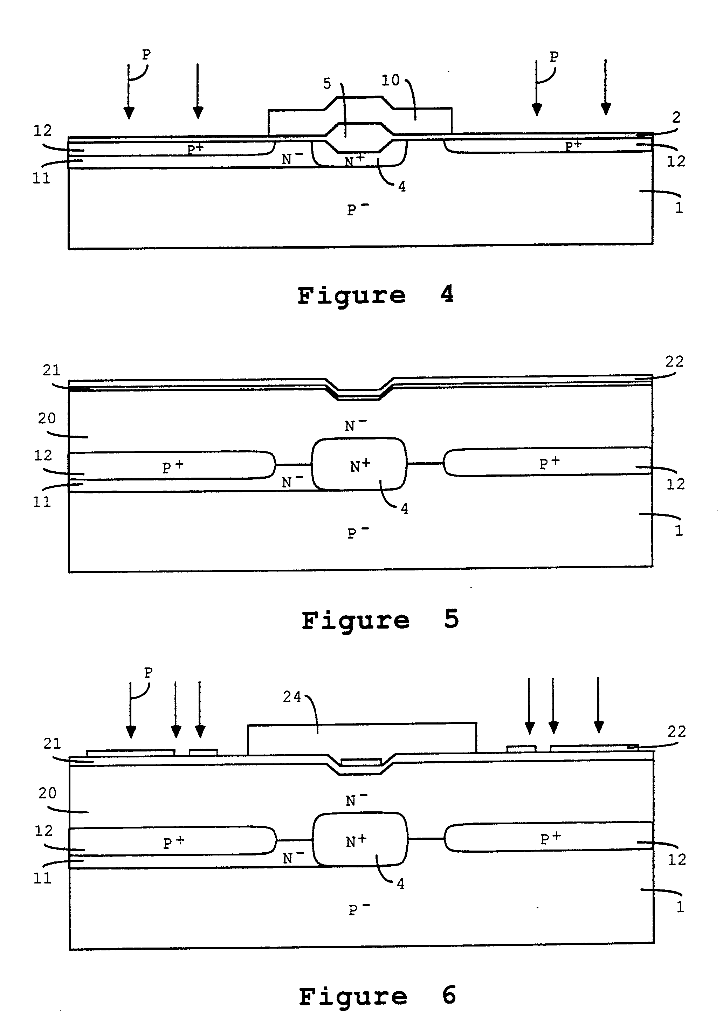

La figure 4, illustre un masquage de la partie centrale par une couche de résine 10, cette partie centrale correspondant à la délimitation entre deux composants, et une implantation dans les autres régions d'un dopant de type P, par exemple du bore sous une énergie de 40 keV et avec une dose de 4 à 5 $10^{14}$ atomes par $cm^2$. Cette implantation est suivie d'un recuit, par exemple à 1160°C pendant deux heures en présence d'azote. On obtient ainsi une couche 11 de type N- résultant de l'implantation 9 décrite en relation avec la figure 3, et des couches 12 de type P+.

Toutes les régions implantées décrites précédemment sont destinées à devenir des couches enterrées après réalisation d'une épitaxie.

La figure 5 illustre la structure obtenue après formation d'une couche épitaxiée 20 de type N-, cette couche épitaxiée étant elle-même revêtue d'une couche d'oxyde mince 21 et d'une couche de nitrure de silicium 22. On notera que, pendant cette épitaxie, les couches précédemment enterrées diffusent vers le haut dans la région épitaxiée. Bien entendu, l'étape d'épitaxie est précédée d'un enlèvement des couches d'oxyde 2 et 5. On notera que le fait d'avoir prévu la couche d'oxyde épais 5 permet d'obtenir un repère sur la surface de la structure après formation de la couche épitaxiée, ce repère pouvant servir à l'alignement des masques ultérieurs. La couche d'oxyde 21 peut avoir une épaisseur de l'ordre de 50 à 100 nm et la couche de nitrure déposée par voie chimique en phase vapeur une épaisseur de 100 à 150 nm.

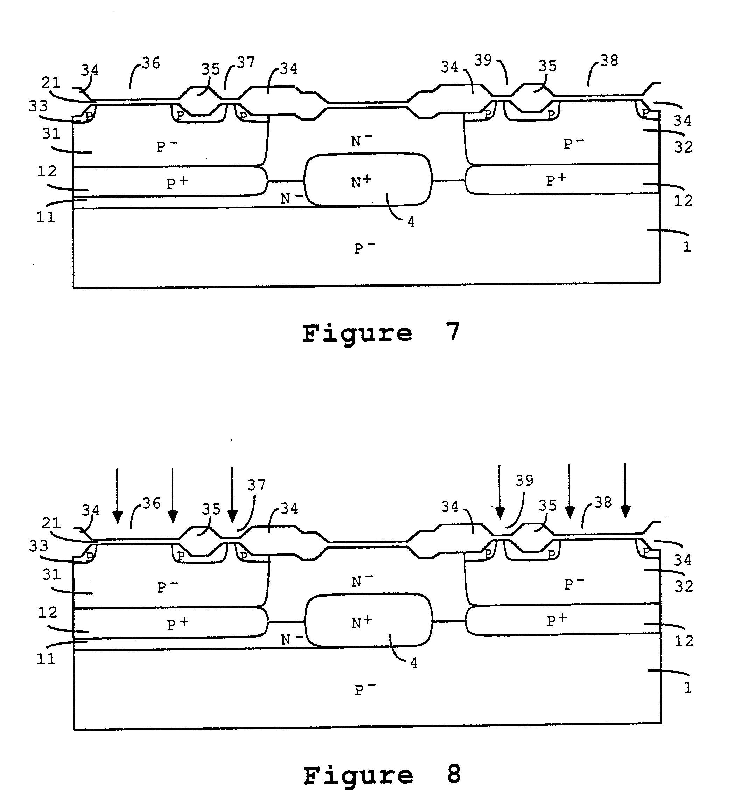

A l'étape illustrée en figure 6, le masque de nitrure est partiellement gravé, de la façon représentée, une couche de résine 24 est déposée pour protéger la partie centrale, et une implantation d'un dopant de type P est réalisée, par exemple une implantation de bore sous une énergie de 120 keV avec une dose de l'ordre de 2 à 3 $10^{12}$ atomes par $cm^2$ suivie d'une deuxième implantation de bore sous une énergie de l'ordre de 30 keV avec une dose de 5 à 7 $10^{13}$ atomes par $cm^2$.

On procède ensuite à une oxydation thermique en atmosphère humide, par exemple à une température de l'ordre de 1000°C, pour former des zones d'oxyde d'une épaisseur de 800 à 1000 nm aux emplacements non protégés par la couche de nitrure et cette couche de nitrure est ensuite éliminée. Pendant cette oxydation, comme l'illustre la figure 7, les dopants de type P précédemment implantés sont redistribués pour former des caissons P- 31 et 32 de relativement faible niveau de dopage et des régions plus fortement dopées 33 sous les zones d'oxyde épais. Parmi les zones d'oxyde épais, on distinguera des régions 34 qui cernent un composant (un caisson P-) et des régions 35 qui partagent le caisson P- où sera formé un composant en deux régions, une région principale et une région auxiliaire dont les fonctions apparaîtront dans la suite. Pour le transistor PNP en cours de fabrication, on désignera par la référence 36 la région principale et par la référence 37 la région auxiliaire et pour le transistor MOS en cours de fabrication, on désignera par la référence 38 la région principale et par la référence 39 la région auxiliaire.

La figure 8 illustre une étape classique d'implantation d'ajustement de seuil pour les régions où seront formés les transistors MOS. Dans cette étape, on élimine également la couche d'oxyde 21 pour la remplacer par une nouvelle couche d'oxyde de grille d'épaisseur choisie pour les transistors MOS que l'on veut fabriquer, par exemple une couche d'oxyde d'une épaisseur de 30 à 50 nm pour obtenir une tension de seuil de 0,5 à 1 voit. On notera que cette étape d'implantation de réglage de seuil peut être effectuée sans masquage puisqu'elle est sans inconvénient pour les régions où seront formés les transistors bipolaires. L'implantation peut par exemple être une implantation de bore sous une énergie de 40 keV à une dose de 1 à 2 $10^{12}$ atomes par $cm^2$. Le résultat de cette implantation n'apparaît pas dans les figures ci-après.

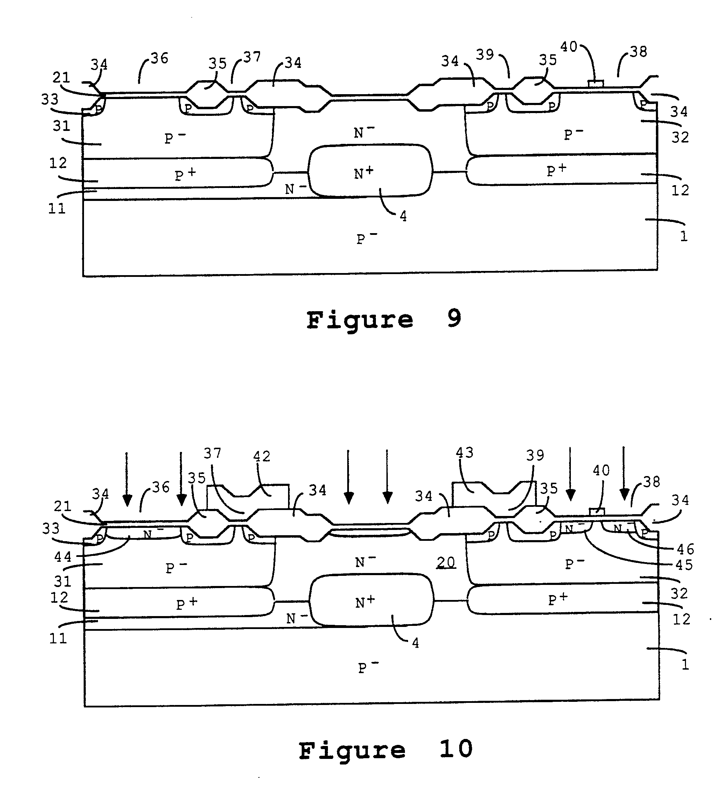

On dépose ensuite (figure 9) sur la structure une couche de silicium polycristallin qui est gravée pour laisser en place des grilles 40 dans les régions 38 des transistors MOS.

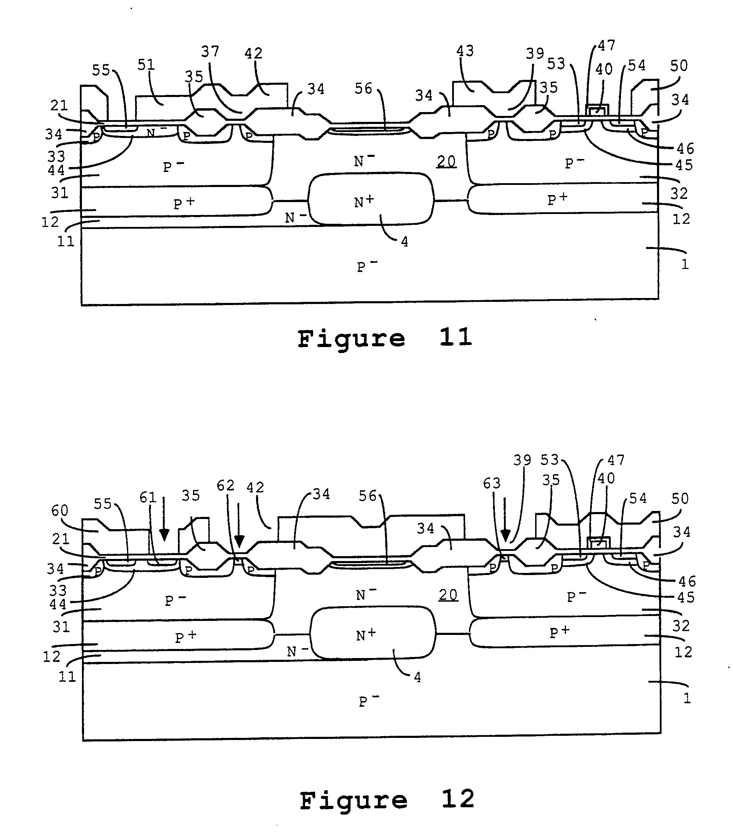

La figure 10 représente une étape suivante au cours de laquelle on a masqué les régions auxiliaires 37 et 39 par des couches de résine 42 et 43 s'arrêtant sur les zones d'oxyde épais 34 et 35 et où l'on a réalisé une implantation d'un dopant de type N à une faible dose, par exemple 2 à 4 $10^{14}$ atomes par $cm^2$ de phosphore sous une énergie de 50 keV. Il en résulte l'obtention de la couche de base 44 des transistors bipolaires et simultanément des régions de drain et de source 45 et 46 du transistor MOS à canal N. Subsidiairement, on surdope légèrement pendant cette étape la couche épitaxiée d'origine 20 dans la région centrale de séparation entre composants.

L'homme de l'art notera que cette étape constitue une des originalités du procédé selon la présente invention.

La figure 11 illustre la formation des régions de contact de drain et source du transistor MOS et de contact de base du transistor bipolaire PNP. Pour passer de la structure de la figure 10 à celle de la figure 11, on commence par réoxyder la grille de silicium polycristallin pour qu'elle forme un masque de plus grande largeur pour l'implantation suivante. La couche d'oxyde est désignée dans la figure par la référence 47. Ensuite, on masque la périphérie de chacun des composants (résine 50) et l'on masque la région du transistor bipolaire où devra être formé le contact d'émetteur (résine 51), les couches de résine 42 et 43 demeurant en place (ou étant remplacées par d'autres couches de résine sen siblement aux mêmes positions). Enfin, on réalise les implantations de source 53, de drain 54) et de contact d'émetteur 55. Simultanément, on surdope la région centrale 56. L'épaisseur de la couche d'oxyde 47 formée sur la grille peut être de l'ordre de 20 à 25 nm et résulter d'un recuit à 950°C pendant une demi-heure. L'implantation N peut être réalisée sous une énergie de 80 keV avec une dose de l'ordre de 4 à 6 $10^{15}$ atomes par $cm^2$.

Dans l'étape de la figure 12, on a déposé une nouvelle couche de résine 60 qui est ouverte pour laisser apparaître les régions auxiliaires 37 et 39 et la région d'émetteur de la région principale 36. On forme ainsi simultanément les régions de contact d'émetteur et de collecteur 61 et 62 du transistor bipolaire et la région de contact de substrat 63 du transistor MOS. Ces régions P + peuvent résulter d'une implantation de bore à 50 keV et à une dose de 2 à 4 $10^{15}$ atomes par $cm^2$.

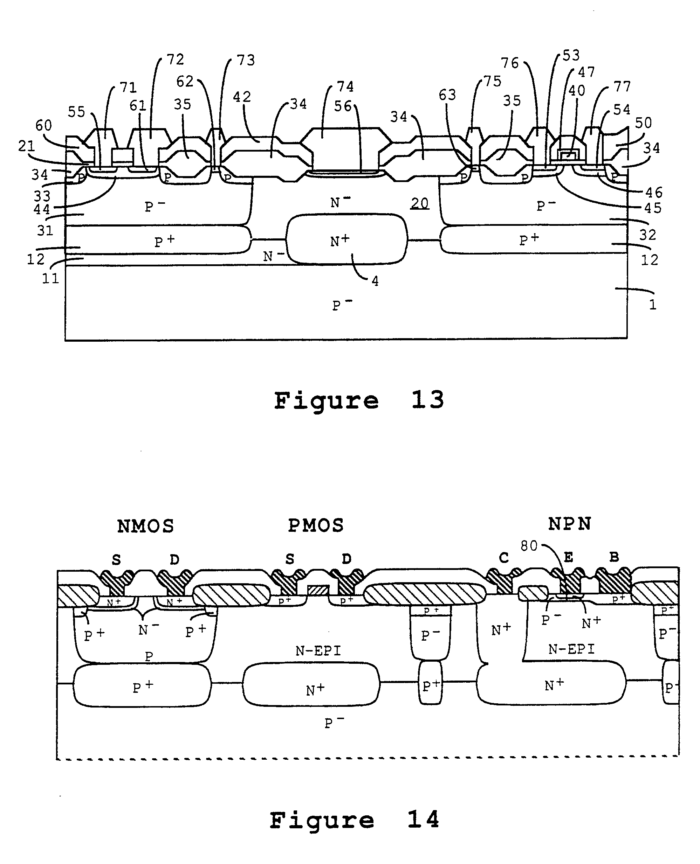

Enfin, la figure 13 représente la structure dans une étape ultérieure après formation de métallisation de base 71, d'émetteur 72, de collecteur 73, de polarisation de caisson 74, de contact substrat 75, de source 76 et de drain 77 (la métallisation de reprise de contact de grille du transistor MOS n'est pas représentée).

Dans ce qui précède, on a décrit un exemple détaillé de réalisation de la présente invention. Il est clair que cette réalisation est susceptible de variantes et de modifications qui apparaîtront à l'homme de l'art. Notamment, tous les types de conductivité pourraient être inversés pour former simultanément un transistor MOS à canal P et un transistor bipolaire de type NPN. L'un des aspects importants de la présente invention réside dans le choix des doses et des énergies d'implantation servant à la formation des régions de type N- 44, 45, 46 puis des régions de type N + 53, 54, 55 et enfin de la région de type P 61, pour que ces dernières régions de type N + et P + se trouvent encastrées dans la région P- sans la traverser.

Grâce à cette disposition, on arrive à fabriquer simultanément des transistors MOS à canal N de type DDD présentant donc une bonne transductance et une tension de seuil convenablement définie et un transistor PNP vertical ayant un gain élevé) par exemple de l'ordre de 100.

D'autre part, il faut noter que la structure selon la présente invention fait partie d'un processus d'ensemble plus complexe de fabrication de circuits intégrés dans lequel d'autres composants peuvent être simultanément formés. A titre d'exemple, on a représenté en figure 14 côte à côte deux transistors MOS complémentaires, à gauche un transistor NMOS identique à celui de l'invention et à droite un transistor PMOS, c'est-à-dire un transistor MOS à canal P. Enfin, à droite de la figure, on a représenté un transistor de type NPN vertical. On a désigné par les lettres S et D les sources et drains des transistors MOS et par C, E et B les collecteur, émetteur et base du transistor bipolaire.

Cette figure ne sera pas décrite en détail mais l'homme de l'art notera que toutes les couches du transistor MOS à canal P peuvent être réalisées simultanément avec le processus précédemment décrit de fabrication du transistor MOS à canal N et du transistor PNP vertical. Pour le transistor NPN vertical, la seule couche supplémentaire est la couche P- de base 80 dans laquelle est formée la diffusion N+ d'émetteur. Cette couche P- 80 correspond pour le transistor NPN à la couche N- 44 du transistor PNP. De même que la couche N- 44 est formée en même temps que des régions N- 45 et 46 dans le transistor NMOS (voir figures 10 à 13), on pourrait former en même temps que la couche P- 80 des régions P- correspondantes dans le transistor PMOS pour lui conférer une structure de type DDD.

**Revendications**

1. Procédé de fabrication d'un circuit intégré comprenant notamment des transistors MOS à canal d'un premier type de conductivité et des transistors bipolaires verticaux du type à émetteur-collecteur du deuxième type de conductivité ces transistors étant formés dans des caissons (31, 32) du deuxième type de conductivité à faible niveau de dopage sur des couches enterrées du deuxième type de conductivité à fort niveau de dopage, chacun de ces caissons étant délimité latéralement par une enceinte d'isolement (34) et étant partagé par une bande d'isolement (35) en une région principale (36 ; 38) et une région auxiliaire (37 ; 39), la partie superficielle des régions auxiliaires étant dopée selon le second type de conductivité et à haut niveau de dopage ; ces régions auxiliaires correspondant au collecteur du transistor bipolaire et à la zone de contact de caisson du transistor MOS ; une grille (40) séparant en deux parties la région principale du transistor MOS,
caractérisé en ce qu'il comprend les étapes successives suivantes, réalisées dans lesdites régions principales après formation des grilles des transistors MOS :
- implanter une région (44 ; 45, 46) du premier type de conductivité à faible niveau de dopage et recuire,
- implanter une région (55 ; 53, 54) du premier type de conductivité à haut niveau de dopage sauf dans un emplacement où sera formé l'émetteur du transistor bipolaire et recuire,
- implanter une région (61) du deuxième type de conductivité et à haut niveau de dopage là où on veut former l'émetteur du transistor bipolaire et recuire,
- les implantations et recuits des régions à haut niveau de dopage du premier et du deuxième type de conductivité étant réalisés de sorte qu'il demeure une partie de la couche résultant de l'implantation du premier type de conductivité à faible niveau de dopage sous chacune de ces régions.

2. Procédé de fabrication d'un circuit intégré selon la revendication 1 dans lequel le premier type de conductivité est le type N, caractérisé en ce que ladite région (44 ; 45, 46) du premier type de conductivité à faible niveau de dopage résulte d'une implantation de phosphore et en ce que ladite région (61) du deuxième type de conductivité et à haut niveau de dopage résulte d'une implantation de bore.

**Figure 1**

**Figure 2**

**Figure 3**

**Figure 4**

**Figure 5**

**Figure 6**

Figure 7

Figure 8

Figure 9

Figure 10

## Figure 11

## Figure 12

**Figure 13**

NMOS        PMOS        NPN

**Figure 14**

Office européen
des brevets

**RAPPORT DE RECHERCHE EUROPEENNE**

Numero de la demande

EP 90 42 0258

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | GB-A-2 208 965 (TEKTRONIX INC.)<br>* Revendications 1,30,36-44 *<br>--- | 1 | H 01 L 21/82<br>H 01 L 27/06 |
| A | GB-A-2 186 117 (SGS MICROELETTONICA S.p.A.)<br>* Revendication 5, figures 11,12 *<br>--- | 1,2 | |
| A | EP-A-0 227 970 (SIEMENS AG)<br>--- | | |
| A | EP-A-0 179 693 (THOMSON-CSF)<br>--- | | |
| A | EP-A-0 097 379 (K.K. TOSHIBA)<br>----- | | |

DOMAINES TECHNIQUES RECHERCHES (Int. Cl.5)

H 01 L

Le présent rapport a été établi pour toutes les revendications

| Lieu de la recherche | Date d'achévement de la recherche | Examinateur |
|---|---|---|
| LA HAYE | 10-08-1990 | ZOLLFRANK G.O. |